Europäisches Patentamt

(19) European Patent Office

Office européen des brevets

(11) Veröffentlichungsnummer: **0 153 454**
**B1**

(12) **EUROPÄISCHE PATENTSCHRIFT**

(45) Veröffentlichungstag der Patentschrift:
**09.08.89**

(51) Int. Cl.⁴: **G 01 R   7/04**

(21) Anmeldenummer: **84113584.1**

(22) Anmeldetag: **10.11.84**

(54) Schaltungsanordnung zur Regelung des Drehmoments von Quotientenmesswerken.

(30) Priorität: **03.12.83 DE 3343850**

(43) Veröffentlichungstag der Anmeldung:
**04.09.85 Patentblatt 85/36**

(45) Bekanntmachung des Hinweises auf die Patenterteilung: **09.08.89 Patentblatt 89/32**

(84) Benannte Vertragsstaaten:
**DE FR GB SE**

(56) Entgegenhaltungen:
**US–A– 3 798 543**
**US–A– 4 155 038**
**US–A– 4 211 971**

(73) Patentinhaber: **VDO Adolf Schindling AG**
**Gräfstrasse 103**
**D-6000 Frankfurt/Main 90 (DE)**

(72) Erfinder: **Wallrafen, Werner, Dipl.-Ing.**
**Birnheck 11**
**D-6233 Kelkheim 3 (DE)**

(74) Vertreter: **Könekamp, Herbert, Dipl.-Ing.**
**Sodener Strasse 9**
**D-6231 Schwalbach (DE)**

Beschreibung

Die Erfindung betrifft eine Schaltungsanordnung zur Regelung des Drehmoments von Quotientenmeßwerken nach dem Oberbegriff des Anspruchs 1.

Generell wirken Quotientenmeßwerke so, daß der Zeigerausschlag ein Maß für den Quotienten der Ströme ist, die durch zwei Spulenzweige des Quotientenmeßwerks fließen. In erster Näherung gehen somit in den Zeigerausschlag die Absolutwerte der Ströme nicht ein, solange ihr Verhältnis gleichbleibt. Dieser grundsätzliche Vorteil des Quotientenmeßwerks ist jedoch dadurch begrenzt, daß bei kleinen Strömen in den Spulenzweigen das erzeugte Drehmoment nicht ausreicht, um das Zeigerwerk mit Sicherheit in die exakte dem Quotienten der Ströme entsprechende Stellung zu bewegen. Wenn zur Verstärkung schwacher Ströme (Meß-) Verstärker eingesetzt werden, sind andererseits die Aussteuergrenzen der Verstärker zu beachten, da anderenfalls, wenn deren Eingangsspannung den vorgegebenen Wert überschreitet, die Ausgangsspannung nicht mehr proportional ist. Diese Genauigkeitsgrenzen des Meßprinzips mit einem Quotientenmeßwerk liegen in der Praxis infolge der Fertigungstoleranzen noch enger. — Störend machen sich diese Genauigkeitsgrenzen bei einer Meßanwendung bemerkbar, bei der die Lage der Horizontalkomponente des Magneterdfeldes zu der Längsachse eines Fahrzeugs gemessen und in einen proportionalen Zeigerausschlag eines Quotientenmeßwerks umgewandelt werden soll. Die Horizontalkomponente der Induktion ist nämlich stark von der geographischen Lage des Fahrzeugs abhängig.

Im einzelnen werden bei einer bekannten Kompaßanlage mit einer Magnetsonde, die nach dem bekannten Prinzip der Flux-gate-Magnetfeldmessung eine Sinussignalspannung und eine Cosinussignalspannung erzeugt, die dem Sinus- bzw. Cosinus des Vektors der horizontalen Komponente der Induktion des die Magnetsonde umgebenden Magnetfeldes bezogen auf eine bestimmte Achse (Fahrzeuglängsachse) entsprechen. Die Sinussignalspannung und die Cosinussignalspannung werden über je eine spannungsgesteuerte Stromquelle, die in zwei Kennlinien-Quadranten arbeitet, in proportionale Ströme umgesetzt, die in je eine der beiden Spulenhälften des Quotientenmeßwerks eingespeist werden. Der Zeigerausschlag dieses Quotientenmeßwerks ist dann proportional dem Arcus-Tangens des Verhältnisses der beiden Signalspannungen. — Wie oben erläutert, kann aber diese Kompaßanlage nur in bestimmten geographischen Lagen befriedigend arbeiten. Deswegen wird bei der Fertigung der Kompaßanlage zumindest ein Bestandteil, nämlich die Magnetsonde, so abgeglichen daß bei dem vorgesehenen Einsatzort die Signalspannungen in einem vorgegebenen Bereich liegen. Dieses Vorgehen bedingt einen größeren Aufwand bei Fertigung und Lagerhaltung.

Aus der US-A-4 155 038 ist bereits eine Schaltung zur Verhältnisbildung bekannt. Dabei handelt es sich jedoch um eine Kalibrierschaltung zur Einpegelung von Unterwasser-Mikrophonen (Hydrophonen), bei der zunächst die Summe und die Differenz der Ausgangssignale des zu kalibrierenden Hydrophons und eines Referenz-Hydrophons gebildet und diese multipliziert werden. Das Ergebnissignal steuert einen Verstärker mit variablem Verstärkungsfaktor am Ausgang des zu kalibrierenden Hydrophons im Sinne einer Angleichung an das Referenz-Hydrophons. Eine Anpassung der Verstärkungsfaktoren abhängig von der Summe der Ausgangssignale ist bei der bekannten Schaltung nicht vorgesehen.

Eine weitere Schaltung zur Bestimmung zweier Signalfolgen, von denen eines der Summe und das andere der Differenz zweier Eingangssignale entspricht, ist aus der US-A-4 211 971 bekannt. Diese beiden Eingangssignale entstehen als Kapazitätsänderungen zweier gegensinnig veränderbarer elektrischer Kapazitäten in einem Wegmesser und werden in einem Verhältnisdetektor zur Unterdrückung von Amplituden- und Frequenzschwankungen ausgewertet. Eine Verstärkungsänderung abhängig von der Größe der Eingangssignale sur Aufrechterhaltung der Proportionalität ist dort ebenfalls nicht vorgesehen.

In hochentwickelten Kompaßanlagen, die einen Abgleich der Ortsmißweisung und der fahrzeugbedingten Deviation ermöglichen, wird ein Analogrechner zur Verarbeitung der Sinussignalspannung und der Cosinussignalspannung verwendet, in dem unter anderem der Betrag des Vektors aus den beiden Signalspannungskomponenten gebildet wird. Dieses sogenannte b-Signal wird dazu herangezogen, den Sinus und den Cosinus der Vektorrichtung der Horizontalkomponente der Induktion zu der gegebenen Achse zu bilden. Es ist nicht versucht worden, dieses b-Signal, welches auch ein Maß für den Betrag der Horizontalkomponente der Induktion darstellt, zur Amplitudennormierung unterschiedlich starker Magnetfelder zu nutzen, indem die Sinus- und Kosinussignalspannungen durch den Betrag des Vektors dividiert wird. Diese Nutzung wäre auch auf die genannten hochwertigen Kompaßanlagen beschränkt, in denen das b-Signal in relativ aufwendiger Weise errechnet wird.

Der Erfindung liegt die Aufgabe zugrunde, eine Schaltungsanordnung zur weniger aufwendigen Regelung des Drehmoments von Quotientenmeßwerken zu schaffen, bei denen je eine Spulenhälfte von einem Strom durchflossen wird, der aus einer verstärkten Signalspannung durch eine in zwei Quadranten arbeitende spannungsgesteuerte Stromquelle erzeugt wird. Diese Schaltungsanordnung soll also ohne einen Analogrechner zur Division durch das sogenannte b-Signal auskommen.

Diese Aufgabe wird durch die in Anspruch 1 angegebene Erfindung gelöst.

Dabei wird unter Summenstrom ein Strom verstanden, der die Summe der einzelnen Versorgungsströme darstellt. Diese Summe kann in außerordentlich einfacher Weise als Summe der Versorgungsströme der beiden in zwei Quadranten arbeitenden spannungsgesteuerten Stromquellen gebildet werden.

Im einzelnen werden die Versorgungsströme der beiden spannungsgesteuerten Stromquellen wie in Anspruch 2 über einen gemeinsamen Summenwiderstand geführt, an dem ein der Summe entsprechender Spannungsabfall auftritt. Der Spannungsabfall steuert Schalter zur entsprechenden Veränderung des Verstärkungsfaktors jedes der beiden (Spannungs-) Verstärker, der zur Verstärkung je einer Signalspannung vorgesehen ist, in übereinstimmender Weise.

In Abhängigkeit von der Summe der Versorgungsströme werden die (Spannungs-) Verstärker selbsttätig so umgeschaltet, daß sich ihr Verstärkungsfaktor zur Ausregelung der Feldstärkeschwankungen ändert.

Nach Anspruch 2 erfolgt die Verstärkungsänderung wenig aufwendig stufenweise mit einem gesteuerten Schalter, der durch den Ausgang eines Komparators betätigt wird. Der Komparator vergleicht eine der Summe der Versorgungsströme der spannungsgesteuerten Stromquellen entsprechende Spannung, die an einem Summenstromwiderstand abfällt, mit einem Schwellwert. Es liegt hier also eine nicht stetige Regelung des Verstärkungsfaktors der (Spannungs-) Verstärker vor. Die Frequenz, mit der die Umschaltungen der Verstärkungsfaktoren erfolgt, ist dabei zweckmäßig durch ein integrierendes Widerstands-Kondensatorglied nach Anspruch 5 begrenzt.

Das integrierende Widerstands-Kondensatorglied nach Anspruch 5 dient ferner zur Bedämpfung des Zeigerausschlags.

Besonders wenig aufwendig wird jede in zwei Meßkennlinien-Quadranten arbeitende spannungsgesteuerte Stromquelle durch einen integrierten Schaltkreis gebildet, dessen Versorgungsstrom unmittelbar einem Maß für den Betrag der Signalspannung, bzw. des proportionalen Stroms am Ausgang der Stromquelle ist.

Wenn die beiden spannungsgesteuerten Stromquellen nach Anspruch 4 durch einen gemeinsamen Vierfach-Operationsverstärker auf einem Chip ausgebildet sind, kann die gemeinsame Versorgung dieses Vierfach-Operationsverstärkers unmittelbar als Summenstrom ausgewertet werden.

Die Umschaltung der Verstärkungsfaktoren der (Spannungs-) Verstärker erfolgt vorteilhaft im Gegenkopplungszweig nach Anspruch 6 durch Zu- bzw. Abschalten eines Widerstands, der nach den bekannten Beziehungen in das Übertragungsverhalten der Verstärkeranordnung eingeht.

Die Erfindung wird im folgenden anhand einer Zeichnung mit 2 Figuren erläutert. Es zeigen :

Fig. 1 ein vereinfachtes Blockschaltbild der Schaltungsanordnung in einer ersten Ausführungsform, und

Fig. 2 ein vereinfachtes Schaltbild einer mit zwei Chips ausgeführten Schaltungsanordnung.

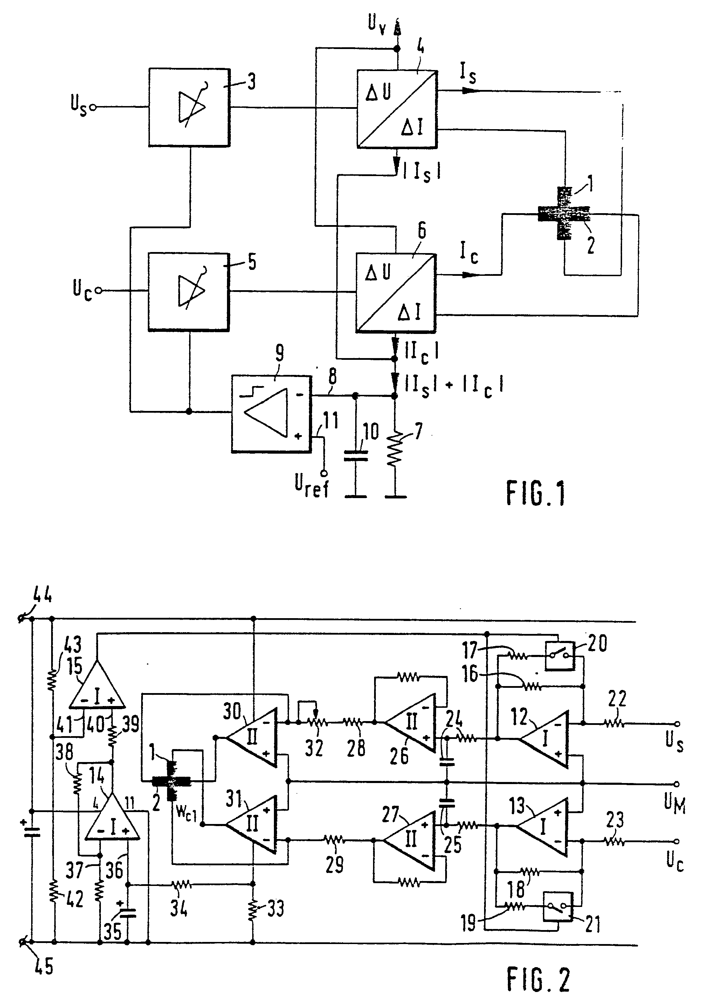

In Fig. 1 ist jeder Spulenhälfte 1 bzw. 2 ein Verstärkerzweig zugeordnet : Zur Verstärkung einer von einer nicht dargestellten Sonde gelieferten Sinussignal-Spannung dient ein umschaltbarer Spannungsverstärker 3, der als Meßverstärker ausgebildet ist. Der Spannungsverstärker 3 steuert eine spannungsgesteuerte Stromquelle 4, an die der Spulenzweig 1 angeschlossen ist.

In analoger Weise ist der Verstärkerzweig mit dem umschaltbaren Spannungsverstärker 5 zur Verstärkung einer Cosinussignalspannung von der Sonde und einer spannungsgesteuerten Stromquelle 6, ausgebildet, welche den Spulenzweig 2 speist.

Mit einer Versorgungsspannung $U_v$ werden beide spannungsgegesteuerten Stromquellen 4 und 6 so gespeist, daß deren Versorgungsströme einen gemeinsamen Summenstromwiderstand 7 durchfließen.

Der Summenstromwiderstand ist an einen Eingang 8 eines Komparators 9 angeschlossen. Ein Kondensator 10 an diesem Eingang dient dazu, den Spannungsverlauf an dem Summenstromwiderstand 7 zu glätten. — Ein zweiter Eingang 11 des Komparators liegt auf dem Potential einer Referenzspannung $U_{ref}$.

Ausgangsseitig ist der Komparator so mit den schaltbaren Spannungsverstärkern 3 und 5 verbunden, daß deren Verstärkungsfaktoren übereinstimmend in Abhängigkeit von der Ausgangsgröße des Komparators verändert werden.

Die spannungsgesteuerten Stromquellen können in zwei Quadranten einer Kennlinie ausgesteuert werden, so daß der Sinusstrom und der Cosinusstrom an ihren Ausgängen die zugehörigen Spulenzweige 1 und 2 zur 360°-Anzeige jeweils in den beiden möglichen Richtungen fließen kann. Dabei wechselt aber der Versorgungsstrom $|I_s|$ bzw. $|I_c|$ seine Richtung nicht, sondern behält sie im Sinne einer Betragsbildung des Stroms $|I_s|$ bzw. $|I_c|$ bei. An dem Summenstromwiderstand 7 fällt also ein der Summe der Beträge der Versorgungsströme $|I_s|$ und $|I_c|$ entsprechender Spannungsabfall auf. Sobald dieser durch den Kondensator 10 geglätteter Spannungsabfall die Referenzspannung $U_{ref}$ überschreitet, werden die Verstärkungsfaktoren der Spannungsverstärker 3 und 5 im Sinne einer Verminderung der Verstärkung gemeinsam umgeschaltet. Damit sinken die Spannungen, welche die Stromquellen 4 und 6 steuern, entsprechend ab, so daß diese nicht übersteuert werden können. Ebenso werden der Sinusstrom und der Cosinusstrom durch die Spulenzweige 1 und 2 sowie die Beträge der entsprechenden Versorgungsströme $|I_s|$ und $|I_c|$ herabgesetzt. Der Komparator schaltet — durch den Kondensator 10 verzögert — die beiden umschaltbaren Spannungsverstärker 3 und 5 wieder auf volle Verstärkung zurück, so daß der beschriebene Ablauf von vorne beginnen kann.

Der Komparator schaltet also in der Art eines Zweipunktreglers, der die Verstärkung der Spannungsverstärker 3 und 5 getaktet umschaltet. Die Taktfrequenz wird dabei durch den Kondensator 10 auf einen günstigen Wert reduziert, der auch eine ruhige Zeigeranzeige in dem Kreuzspulinstrument entsprechend dem Quotienten des Sinusstroms zu dem Cosinusstrom ermöglicht.

In Fig. 2 ist je ein Vierfach-Operationsverstärker I und ein Vierfach-Operationsverstärker II auf einem Chip ausgebildet.

Zu dem Vierfach-Operationsverstärker I gehören zwei Spannungsverstärker 12, 13, 14, sowie ein zweistufiger Komparator 15.

Jeder Spannungsverstärker 12 bzw. 13 weist zwei Gegenkopplungs-Widerstände 16, 17 bzw. 18, 19 auf. Der Gegenkopplungs-Widerstand 17 bzw. 19 ist durch einen gesteuerten Halvleiterschalter 20 bzw. 21 in den Gegenkopplungszweig einschaltbar.

Der Verstärkungsfaktor jedes Spannungsverstärkers ergibt sich nach der bekannten Beziehung aus dem Verhältnis des Gegenkopplungswiderstands 16, ggfs. parallel mit 17, zu dem Eingangswiderstand 22. Die Verstärkung des Spannungsverstärkers 13 ist in gleicher Weise umschaltbar.

Jeder Ausgang eines Spannungsverstärkers speist über eine Widerstandskondensator-Kombination 24 bzw. 25 zur zusätzlichen Dämpfung einen Eingang eines Impedanzwandler-Verstärkers 26 bzw. 27. Über je einen Kopplungswiderstand 28 bzw. 29 steht der Impedanzwandler mit einer zweiten Verstärkerstufe 30 bzw. 31 in Verbindung, die den Impedanzwandler zur spannungsgesteuerten Stromquelle für einen der Spulenzweige 1 bzw. 2 vervollständigt.

Ein dem Kopplungswiderstand 28 nachgeschalteter Einstellwiderstand 32 dient zum Abgleich beider Kanäle, um Verstärkungs- und/oder Meßwerksfehler auszugleichen.

Der gesamte Versorgungsstrom des Vierfach-Operationsverstärkers II durchfließt einen Summenstromwiderstand 33. Dieser steht über einen Längswiderstand 34, der zusammen mit einem Kondensator 35 eine integrierende Widerstands-Kondensator-Kombination bildet, mit einem Eingang 36 des zweistufigen Komparators in Verbindung, dessen zweiter Eingang 37 über einen Widerstand 38 gegengekoppelt ist. Der Ausgang dieser Verstärkerstufe 14 ist über einen Widerstand 39, der eine Ruhestromkompensation bewirkt, mit einem ersten Eingang 40 der Komparatorstufe 15 verbunden. Ein zweiter Eingang 41 der zweiten Komparatorstufe wird über einen Spannungsteiler 42, 43 mit der Referenzspannung beaufschlagt.

Die Klemmen 44, 45 liegen an einer stabilisierten Versorgungsspannung.

Die grundätzliche Wirkungsweise dieser Schaltungsanordnung stimmt mit der zu Fig. 1 besprochenen Funktion überein :

Die Stromaufnahme des Vierfach-Operationsverstärkers II ist als Summe der Beträge eines sinusförmigen Stromverlaufs entsprechend der Sinussignalspannung $U_s$ und des Cosinusförmigen Stromverlaufs entsprechend der Cosinussignalspannung $U_c$ insgesamt annähernd unabhängig von der Lage der Horizontalkomponente der Erdinduktion zu der Referenzlinie (Mittellinie). Dieser Summenstrom erzeugt wiederum an dem Summenstromwiderstand 33 einen Spannungsabfall, der über die integrierende Widerstands-Kondensator-Kombination 34, 35 und die Verstärkerstufe 14 die zweite Komparatorstufe 15 so steuert, daß je nach Überschreiten oder Unterschreiten der Referenzspannung die gesteuerten Schalter 20, 21 geschlossen oder geöffnet werden. Die Verstärkungsfaktoren der Verstärker 12, 13 werden damit insgesamt so im Takt umgeschaltet, daß sich an dem Summenwidertand 33 ein Spannungsmittelwert einstellt, der ein durch die Dimensionierung vorbestimmter Teil der Referenzspannung $U_{ref}$ ist. Dieser Spannungsmittelwert wird infolge der Regelung annähernd konstant gehalten. Daraus ergeben sich konstante Summenbeträge der Ströme durch die beiden Spulenzweige 1 und 2 praktisch unabhängig von der Lage des Fahrzeugs, in dem die Sonde eingebaut ist, zur horizontalen Erdfeldkomponente und praktisch unabhängig zu dem Betrag der Erdfeldinduktion an dem jeweiligen geographischen Ort. Desgleichen wird dafür gesorgt, daß die Steuerspannungen, die die zweistufigen spannungsgesteuerten Stromquellen 26, 30 bzw. 27, 31 steuern, vorgegebene Werte nicht überschreiten. Die beiden durch den Vierfach-Operationsverstärker 4 gebildeten spannungsgesteuerten Stromquellen erzeugen daher Sinus- und Cosinusströme, die weitgehend proportional den Sinussignalspannungen und Cosinussignalspannungen sind.

**Patentansprüche**

1. Schaltungsanordnung zur Regelung des Drehmoments von Quotientenmeßwerken mit zwei gekreuzten Spulenzweigen, insbesondere von Kompaßanzeigern, bei denen je ein Spulenzweig (1 bzw. 2) mit je einer Zwei-Quadranten spannungsgesteuerten Stromquelle (4, 6) verbunden ist, die jeweils über einen Verstärker (3, 5) mit einer von einer Sonde erzeugten Sinussignal-Spannung bzw. Cosinussignal-Spannung, die dem Sinus bzw. Cosinus des Vektors der horizontalen Komponente der Induktion des die Sonde umgebenden Magnetfeldes bezogen auf eine bestimmte Achse entsprechen, gespeist wird, dadurch gekennzeichnet, daß Mittel zur Bildung der Summe der Versorgungsströme beider spannungsgesteuerter Stromquellen (4, 6) vorgesehen sind und daß die Verstärkungsfaktoren beider Verstärker (3, 5) in Abhängigkeit von der Summe der Versorgungsströme selbsttätig umschaltbar sind.

2. Schaltungsanordnung nach Anspruch 1, dadurch gekennzeichnet, daß in eine die Summe der Versorgungsströme führende Leitung ein Summenstrom-Wider-stand (7) eingefügt ist, der mit einem Eingang (8) eines Komparators (9) in Verbindung steht, und daß zur Veränderung des Verstärkungsfaktors jeder der beiden Verstärker (3, 5) ein gesteuerten Schalter vorgesehen ist, der durch den Ausgang des Komparators (9) steuerbar ist.

3. Schaltungsanordnung nach Anspruch 1 oder 2, dadurch gekennzeichnet, daß jede spannungsgesteuerte Stromquelle (4, 6) durch einen integrierten Schaltkreis gebildet ist und daß die Stromversorgungsleitungen beider integrierten Schaltkreise uber den Summenstromwiderstand (7) geführt sind.

4. Schaltungsanordnung nach Anspruch 1 oder 2, dadurch gekennzeichnet, daß daß jede spannungsgesteuerte Stromquelle im wesentlichen aus zwei in Signalmeßrichtung hintereinander geschalteten Operationsverstärkern (26, 30 bzw. 27, 31) gebildet ist, die als Impedanzwandler zum Speisen eines der beiden Spulenzweige (1, 2) mit einem der Sinussignal-Spannung proportionalen Strom geschaltet sind, daß die insgesamt vier Operationsverstärker (26, 27, 30, 31) als Vierfach-Operationsverstärker auf einem Chip ausgebildet sind und daß in einer gemeinsamen Versorgungsstromleitung der Vierfach-Operationsverstärker der Summenstrom-Widerstand (33) angeordnet ist.

5. Schaltungsanordnung nach Anspruch 2 und 3 oder Anspruch 2 und 4, dadurch gekennzeichnet, daß der Eingang (36) des Komparators (14, 15) über ein integrierendes Widerstands-Kondensatorglied (34, 35) mit dem Summenstromwiderstand (33) in Verbindung steht.

6. Schaltungsanordnung nach einem der vorangehenden Ansprüche, dadurch gekennzeichnet, daß die Verstärkungsfaktoren der Verstärker (12, 13) durch je einen gesteuerten Halbleiterschalter (20 bzw. 21) in einem Widerstands-Gegenkopplungszweig (16, 17 bzw. 18, 19) des Verstärkers umschaltbar sind.

## Claims

1. Circuit arrangement for adjusting the torque of quotient measuring instruments having two crossed coil branches, especially of compass indicators, in which a coil branch (1 or 2) is connected in each case to respectively one two-quadrant voltage-controlled current source (4, 6), which is supplied in each case via an amplifier (3, 5) with a sine-wave voltage or cosine-wave voltage generated by a probe, which voltages correspond to the sine or cosine of the vector of the horizontal component of the induction of the magnetic field surrounding the probe with reference to a definite axis, characterized in that means are provided for forming the sum of the supply currents of the two voltage-controlled current sources (4, 6), and in that the amplification factors of the two amplifiers (3, 5) are switchable as a function of the sum of the supply currents.

2. Circuit arrangement according to Claim 1, characterized in that there is inserted in a line conducting the sum of the supply currents a sum-current resistor (7), which is connected to the input (8) of a comparator (9), and in that there is provided for the purpose of altering the amplification factor of each of the two amplifiers (3, 5) a controlled switch, which can be controlled via the output of the comparator (9).

3. Circuit arrangement according to Claim 1 or 2, characterized in that each voltage-controlled current source (4, 6) is formed by an integrated circuit, and in that the current supply lines of the two integrated circuits are routed via the sum-current resistor (7).

4. Circuit arrangement according to Claim 1 or 2, characterized in that each voltage-controlled current source is formed essentially of two operational amplifiers (26, 30 or 27, 31) connected one after another in the direction of signal measurement and wired as impedance converters for supplying one of two coil branches (1, 2) with a current proportional to the sine-wave voltage, in that the altogether four operational amplifiers (26, 27, 30, 31) are constructed as quad operational amplifiers on a chip, and in that the sum-current resistor (33) is arranged in a common supply current line of the quad operational amplifiers.

5. Circuit arrangement according to Claim 2 and 3 or Claim 2 and 4, characterized in that the input (36) of the comparator (14, 15) is connected to the sum-current resistor (33) via an integrating resistor-capacitor element (34, 35).

6. Circuit arrangement according to one of the preceding claims, characterized in that the amplification factors of the amplifiers (12, 13) can be switched in ach case by a controlled semiconductor switch (20 or 21) in a negative feedback resistor branch (16, 17 or 18, 19) of the amplifier.

## Revendications

1. Circuit destiné à ajuster le moment de torsion d'un quotientmètre qui comporte deux branches formées par des bobines en croix, notamment pour instruments indicateurs à boussole, dans lesquels chaque bobine (1 ou 2) est connectée à une source de courant respective (4, 6) à tension pilote à deux quadrants, dont chacune est alimentée, par l'intermédiaire d'un amplificateur (3, 5), par une tension de signal « sinus » ou une tension de signal « cosinus », respectivement, produite par une sonde et correspondant respectivement au sinus et au cosinus de l'angle que le vecteur de la composante horizontale de l'induction du champ magnétique environnant cette sonde fait avec un axe déterminé, circuit caractérisé en ce qu'il est prévu des moyens destinés à donner la somme des courants d'alimentation des deux sources de courant (4, 6) à tension pilote et en ce que les facteurs d'amplification des deux amplificateurs (3, 5) peuvent être modifiés automatiquement en fonction de la valeur de cette somme des courants d'alimentation.

2. Circuit selon la revendication 1, caractérisé en ce qu'il comporte un conducteur dans lequel passe la totalité des courants d'alimentation et sur lequel est branché une résistance (7) de courant total, qui est connectée à une entrée (8) d'un comparateur (9) et en ce que, pour faire alterner le facteur d'amplification de chacun des deux amplificateurs (3, 5), il est prévu un interrupteur qui est commandé par la sortie de ce comparateur (9).

3. Circuit selon la revendication 1 ou 2, caractérisé en ce que chaque source (4, 6) de courant à tension pilote est formée par un circuit intégré, et en ce que les conducteurs d'alimentation en courant de ces deux circuits intégrés sont reliés à la résistance (7) de courant total.

4. Circuit selon la revendication 1 ou 2, caractérisé en ce que chaque source de courant à tension pilote est formée essentiellement par deux amplificateurs opérationnels (26, 30 ; 27, 31) qui se succèdent dans le sens de la mesure des signaux et qui fonctionnent en convertisseur d'impédance destiné à alimenter l'une des deux bobines (1, 2) avec un courant proportionnel à la tension de signal « sinus » ; en ce que l'ensemble de ces quatre amplificateurs (26, 27, 30, 31) est formé en tant qu'amplificateur à quadruple action sur une plaquette à circuit imprimé ; et en ce que la résistance (33) de courant total est disposée dans un conducteur commun d'alimentation de cet amplificateur à quadruple action.

5. Circuit selon les revendications 2 et 3 ou les revendications 2 et 4, caractérisé en ce que l'entrée (36) du comparateur (14, 15) est connectée, par l'intermédiaire d'un élément résistance-condensateur intégrateur (34, 35), à la résistance (33) de courant total.

6. Circuit selon l'une des revendications précédentes, caractérisé en ce que les facteurs d'amplification des amplificateurs (12, 13) peuvent être modifiés par un interrupteur (20, 21) à semiconducteur, piloté, monté dans une branche de contre-réaction à résistances (16, 17 ; 18, 19) de l'amplificateur respectif.

FIG.1

FIG.2